Europäisches Patentamt

(19) European Patent Office

Office européen des brevets

(11) Numéro de publication: **0 024 226**
**B1**

(12) ## FASCICULE DE BREVET EUROPEEN

(45) Date de publication du fascicule du brevet:
23.03.83

(21) Numéro de dépôt: 80401118.7

(22) Date de dépôt: 29.07.80

(51) Int. Cl.³: **G 06 J 1/00, H 03 K 13/08**

(54) **Circuit de traitement de signaux analogiques périodiques et dispositif utilisant un tel circuit.**

(30) Priorité: 10.08.79 FR 7920521

(43) Date de publication de la demande:
25.02.81 Bulletin 81/8

(45) Mention de la délivrance du brevet:
23.03.83 Bulletin 83/12

(84) Etats contractants désignés:
**BE DE GB IT NL SE**

(56) Documents cités:
**DE-A-2 318 519**
**FR-A-2 346 905**
**US-A-3 573 794**
**IEEE INTERNATIONAL CONVENTION RECORD,**
**vol. 15, no. 3, 20/23 Mars 1967, pages 81—86 U.S.A.**
**K. S. BONWIT: »Cessam: Conversion Equipment**
**System, Surface-to-air missiles«**

(73) Titulaire: THOMSON-CSF, 173, Boulevard Haussmann,
F-75379 Paris Cedex 08 (FR)

(72) Inventeur: Delegue, François, "THOMSON-CSF" -
SCPI 173, Boulevard Haussmann, F-75360 Paris
Cedex 08 (FR)

(74) Mandataire: Trocellier, Roger et al, THOMSON-CSF
SCPI 173, Bld Haussmann, F-75379 Paris Cedex 08 (FR)

## Circuit de traitement de signaux analogiques périodiques et dispositif utilisant un tel circuit

L'invention concerne un circuit de traitement de signaux analogiques périodiques.

De manière plus précise, le traitement concerné par l'invention s'adresse à des signaux produits par une pluralité de senseurs, ou capteurs, délivrant chacun un signal de mesure de la forme $V_M = KV_R\theta$ où K est une constante, $V_R$ un signal périodique de référence alimentant le capteur et $\theta$ l'information à mesurer correspondant à un déplacement linéraire ou angulaire.

Les potentiomètres inductifs linéaires appelés encore »linvars« (de l'appellation anglosaxonne »linear variometer«) produisent de tels signaux. Ils constituent des transformateurs à couplage variable dont la tension induite est une fonction linéaire de l'information de position $\theta$ à mesurer. Cette dernière correspond au décalage angulaire du rotor dans le cas de réalisation sous forme de machine tournante. Il existe également des réalisations à déplacement linéaire, d'un noyau par exemple, pour faire varier le couplage et recueillir la tension induite aux bornes du bobinage correspondant.

Ces capteurs inductifs sont généralement réalisés dans des dispositifs dotés d'une unité logique de calcul qui effectue un traitement numérique des données et il s'avère par suite nécessaire d'introduire un circuit intermédiaire effectuant les transformation et conversion en vue d'une exploitation par le calculateur.

L'objet principal de l'invention est de réaliser un tel circuit sous une forme simple qui se traduit par une compacité plus élevée et un gain en poids et procurant, comme il apparaîtra ultérieurement une fiabilité accrue. Ces propriétés sont particulièrement avantageuses pour réaliser un dispositif de commande électriques de vol selon une application plus particulièrement envisagée pour l'invention. Parmi d'autres domaines d'applications possibles on peut noter celui de la commande numérique de machines.

La solution conventionnelle pour le traitement des signaux périodiques $V_M$ et $V_R$ provenant des différents capteurs consiste à les transformer d'abord en signaux continus. Chaque signal est appliqué dans ce but à un circuit démodulateur effectuant une démodulation crête ou de surface, et qui est suivi d'un circuit filtre. Les signaux obtenus en sortie des filtres doivent unsuite faire l'objet d'une conversion analogique-numérique par des procédés connus (codeur à approximations successives, codeur à rampes simples ou à rampes multiples) fournissant l'information $\theta_{Ri}$ donnée par le rapport entre le signal de mesure $V_{Mi}$ et le signal de référence $V_{Ri}$ associé. Les différents rapports $V_{M1}/V_{R1}$, $V_{M2}/V_{R2}$, ... $V_{Mn}/V_{Rn}$ peuvent ainsi être stockés séquentiellement dans une mémoire du calculateur. Grâce à un multiplexage des sorties filtres on peut utiliser un circuit codeur analogique-numérique unique élaborant le rapport $V_{Mi}/V_{Ri}$, mais qui constituera cependant l'élément le plus coûteux de la chaîne. Pour des raisons de temps de réaction des démodulateurs et surtout des filtres qui les suivent, il est par contre pratiquement impossible d'obtenir une voie unique d'acquisition par multiplexage de ces éléments qui doivent donc être réalisés sous forme de 2n voies indépendantes traitant respectivement les différents signaux $V_{M1}$ à $V_{Mn}$ et $V_{R1}$ à $V_{Rn}$.

Un circuit de traitement conforme à l'invention remédie à ces inconvénients en élaborant les diverses informations $\theta$ à mesurer sans utiliser de démodulateurs ni de filtres.

Il est connu par la publication DE-A-2 318 519 un circuit de conversion numérique d'un signal analogique périodique et de stockage des valeurs numériques obtenues. Ce circuit utilise un registre à décalage à réaction en tant que mémoire. Les valeurs numériques stockées dans le registre y circulent à la période du signal analogique et un circuit additionneur-soustracteur est inséré dans la boucle de réaction pour additionner ou soustraire à la valeur numérique renvoyée, un signal de sortie binaire d'un discriminateur, ce signal étant formé à partir de la tension d'écart résultant d'une comparaison différentielle entre le signal analogique à convertir et la tension de sortie d'un convertisseur numérique-analogique alimenté par la valeur numérique issue du registre.

Un tel circuit de conversion correspond au préambule de la revendication 1 et nécessite d'être adapté et de comporter des moyens complémentaires pour répondre au problème posé par le traitement envisagé de signaux analogiques périodiques délivrés par une pluralité de capteurs du type linvar. Certains des aménagements apportés consistent en des circuits multiplexeurs pour sélectionner les signaux d'un seul capteur à la fois. L'utilisation de multiplexeurs pour effectuer un distributeur en temps partagé de signaux d'appareils synchros est connue par »IEEE INTERNATIONAL CONVENTION RECORD« vol. 15, n° 3, 20/23 mai 1967, pages 81 – 86 – USA. – article de K. S: BONWIT intitulé »CESSAM: Conversion Equipment System, Surface-to-air missiles«, ou par la publication FR-A-2 346 905.

Selon l'invention, le circuit de traitement est déterminé en sorte que chaque signal de mesure $V_{Mi}$ est comparé dans le circuit comparateur au signal de référence $V_{Ri}$ que lui est associé après que ce dernier ait été multiplié par un coefficient analogique qui correspond à une valeur numérique stockée dans le circuit mémoire rebouclé sur lui-même à travers le circuit additionneur-soustracteur, ce dernier étant commandé à l'incrémentation ou à la décrémentation en fonction de l'état présenté par la sortie numérique du comparateur, en sorte de rallier la valeur réelle $V_M/V_R$ pour la valeur stockée à un quantum d'incrémentation près.

L'invention, telle qu'elle est caractérisée dans les revendications, comporte une mémoire commandée par un signal d'horloge et rebouclée sur elle-même à travers un additionneur-soustracteur, un convertisseur numérique-analogique alimenté par la sortie mémoire, un comparateur différentiel pour comparer un signal analogique à traiter avec la sortie du convertisseur et un circuit de commande à l'incrémentation et à la décrémentation du circuit additionneur-soustracteur à partir de la sortie du comparateur, le circuit de traitement étant destiné à traiter les signaux analogiques d'une pluralité n de capteurs du type potentiomètre inductif linéaire délivrant chacun un signal induit $V_{Mi}$ proportionnel au déplacement à mesurer et au signal de référence $V_{Ri}$ alimentant le capteur en vue d'exploitation de ces signaux par un calculateur numérique annexe, et étant caractérisé en ce que le comparateur est à sortie numérique, que le circuit à commande comporte des moyens d'élaboration du signal de commande d'incrémentation-décrémentation pour préciser une information absolue de la comparaison lorsque les signaux à comparer sont de polarité opposée, et des moyens de validation de la commande d'incrémentation-décrémentation pour une amplitude du signal de référence extérieure à une plage déterminée correspondant aux passages synchrones à zéro des signaux $V_{Mi}$ et $V_{Ri}$ à traiter, et qu'il comporte, en outre, un multiplexeur permettant d'appliquer successivement les 2n signaux des capteurs en transmettant à chaque fois le signal induit avec le signal de référence du capteur correspondant, un circuit multiplicateur interposé entre la sortie du convertisseur et le comparateur pour multiplier le signal de référence par la valeur stockée en mémoire convertie en analogique, en sorte de mémoriser successivement les valeurs $V_{Mi}/V_{Ri}$ représentatives des déplacements respectifs du capteur.

D'autres particularités et avantages de la présente invention apparaîtront dans la description qui suit donnée à titre d'exemple non limitatif à l'aide des figures annexées qui représentent:

— la fig. 1, un diagramme simplifié d'un circuit de traitement de signaux analogiques périodiques conforme à l'invention;
— les figs. 2a à 2d et la fig. 3, des formes d'ondes relatives au fonctionnement du circuit selon la fig. 1;
— la fig. 4, un diagramme d'un circuit de traitement selon l'invention, et
— la fig. 5, un schéma d'une application à un dispositif de commandes électriques de vol.

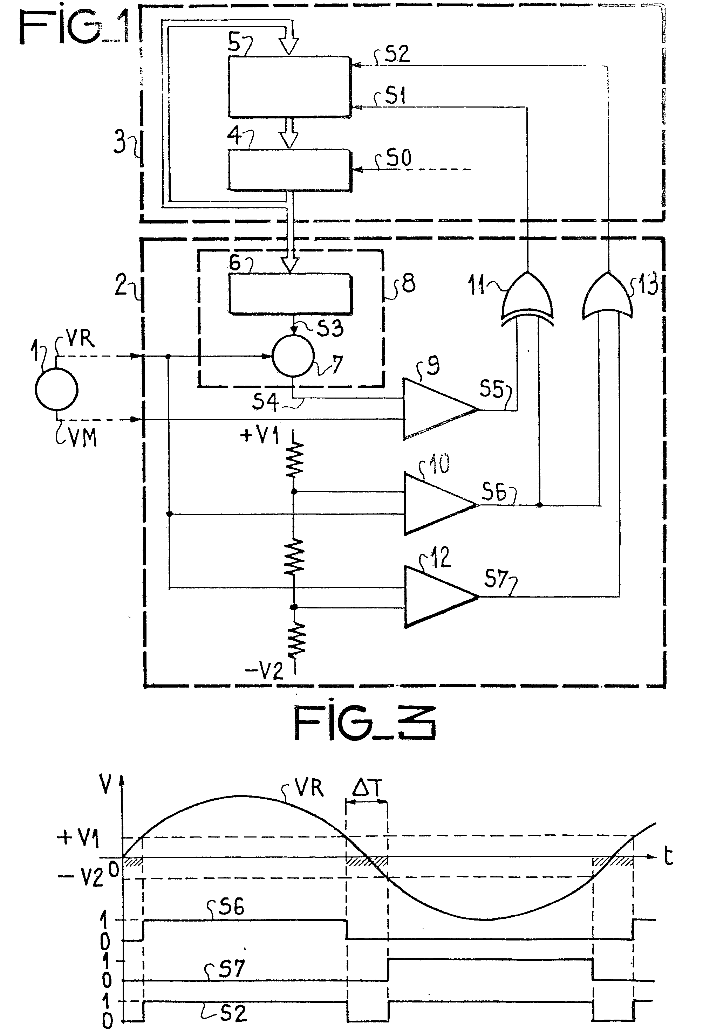

Le procédé mis en oeuvre apparaît sur le diagramme de la fig. 1 où il n'a pas été considéré, par souci de simplification, qu'une paire de signaux $V_M$ et $V_R$ à traiter en provenance d'un capteur annexe 1. Le circuit de traitement a été divisé en deux sous-ensembles 2 et 3 correspondant sensiblement à la partie effectuant un traitement analogique et à celle effectuant un traitement numérique. Cette dernière partie comporte une mémoire 4 du type registre, rebouclée sur elle-même à travers un circuit additionneur-soustracteur 5. Le registre 4 est cadencé par un signal d'horloge So; outre un bit de signe, le nombre N de bits du registre sera déterminé en fonction de la précision désirée. A chaque signal d'horloge, le contenu du registre est accru d'un quantum déterminé (incrémentation) par exemple la valeur 1, ou diminué de ce quantum (décrémentation), ou reste identique à lui-même, selon les deux états de commande possible de chacun des signaux S1 et S2 appliqués au circuit 5. Le signal S1 commande le signe de l'opération somme et constitue le signal d'incrémentation/décrémentation et le signal S2 dit de validité autorise ou non l'opération selon la table de vérité suivante:

| S 1 | S 2 | ACTION EFFECTUEE PAR LE CIRCUIT 5 |
|-----|-----|-----------------------------------|
| 1 | 1 | ADDITION |
| 0 | 1 | SOUSTRACTION |
| 1 | 0 | PAS D'ACTION |
| 0 | 0 | PAS D'ACTION |

La sortie du registre 4 est transmise d'autre part au sous-ensemble 2 à un circuit de conversion numérique-analogique 6 suivi d'un circuit multiplicateur analogique 7, lequel reçoit par une première entrée la sortie S3 du circuit de conversion et, par une deuxième entrée, le signal de référence $V_R$. Les circuits 6 et 7 peuvent être réalisés en circuits intégrés sous forme d'un circuit unique 8 du type convertisseur N/A-multiplicateur. La sortie S4 du multiplicateur est comparée au signal de mesure $V_M$ dans un circuit comparateur 9 à sortie numérique. Le signal S5 prélevé sur cette sortie a par exemple la valeur 1 lorsque S5 est supérieur à $V_M$ et 0 dans le cas inverse.

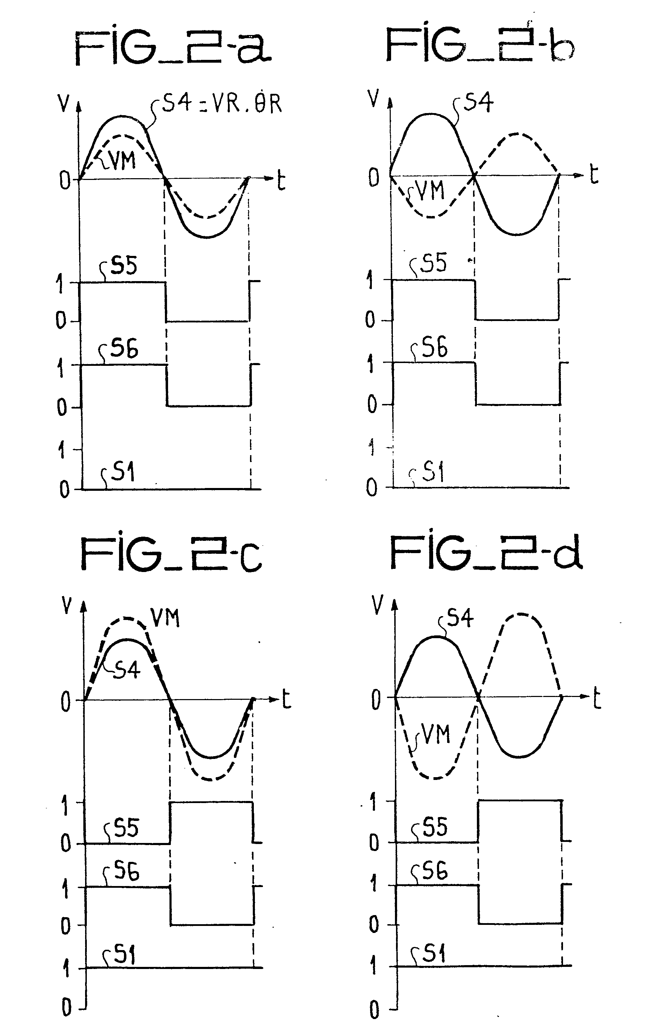

Les signaux $V_M$ et $V_R$ du type considéré sont périodiques et s'annulent aux mêmes instants. Les différentes configurations possibles sont représentées sur les figures 2a à 2d, le signal $V_R$ étant considéré de forme sinusoïdale (signal alternatif). Le signal S4 correspond au signal $V_R$ multiplié par la valeur de conversion S3; en appelant $\Theta_R$ cette valeur analogique de recopie stockée sous forme binaire dans le registre 4 on obtient $S4 = V_R \cdot \Theta_R$. Selon que $V_R \cdot \Theta_R$ est supérieur ou inférieur à $V_M$ et en phase ou en opposition de phase avec celui-ci, on obtient les quatres configurations représentées au dessous desquelles figure la variation correspondante du signal S5 résultant de la comparaison en 9. On peut se rendre compte que l'information S5 est insuffisante pour commander l'incrémentation ou la décrémentation, en comparant les figures 2a et 2c d'une part et les figures 2b et 2d d'autre part. Il s'avère donc nécessaire d'inverser l'information instantanée S5 ($V_M > \theta_R V_R$ et $V_M < \theta_R V_R$) pour tenir compte de l'inversion de polarité du signal de référence $V_R$ et obtenir une information absolue de la comparaison qui se traduira par l'ordre d'incrémentation ou de décrémentation S1. Cette fonction est assurée au moyen d'un deuxième circuit comparateur 10 à sortie numérique et d'un circuit OU exclusif 11. Le signal de référence $V_R$ est comparé dans le circuit 10 à une tension $V_1$ que l'on suppose nulle à priori, en sorte que les états 1 et 0 de la sortie S6 de ce comparateur traduisent respectivement la polarité positive et négative du signal $V_R$. Les signaux S5 et S6 sont appliqués aux entrées du circuit OU exclusif 11 qui délivre l'information incrémentation ou décrémentation S1 correspondante. L'additionneur-soustracteur 5 corrige la valeur de $\theta_R$ dans le sens favorable pour rallier la valeur $V_M/V_R$. Lorsque l'équilibre est atteint, le contenu $\theta_R$ oscille autour de la valeur $V_M/V_R$ en l'encadrant à un quantum d'incrémentation-décrémantation près. La fonction finale réalisée est celle d'un codeur analogique-numérique périodique à poursuite.

Il y a lieu de considérer que le signal d'horloge S0 permet d'échantillonner les signaux et que la fréquence d'horloge est déterminée d'une part, en fonction de celle 1/T des signaux à traiter pour obtenir un nombre donné d'échantillons par période T et d'autre part, en sorte de prélever des échantillons distincts au cours des périodes successives et parcourir ainsi la totalité des signaux. La fréquence d'horloge ne doit donc pas être un multiple ou un sous-multiple de la fréquence 1/T des signaux $V_R$ et $V_M$; ainsi les échantillons sont prélevés de manière non corrélée par rapport au signal $V_M$ à coder.

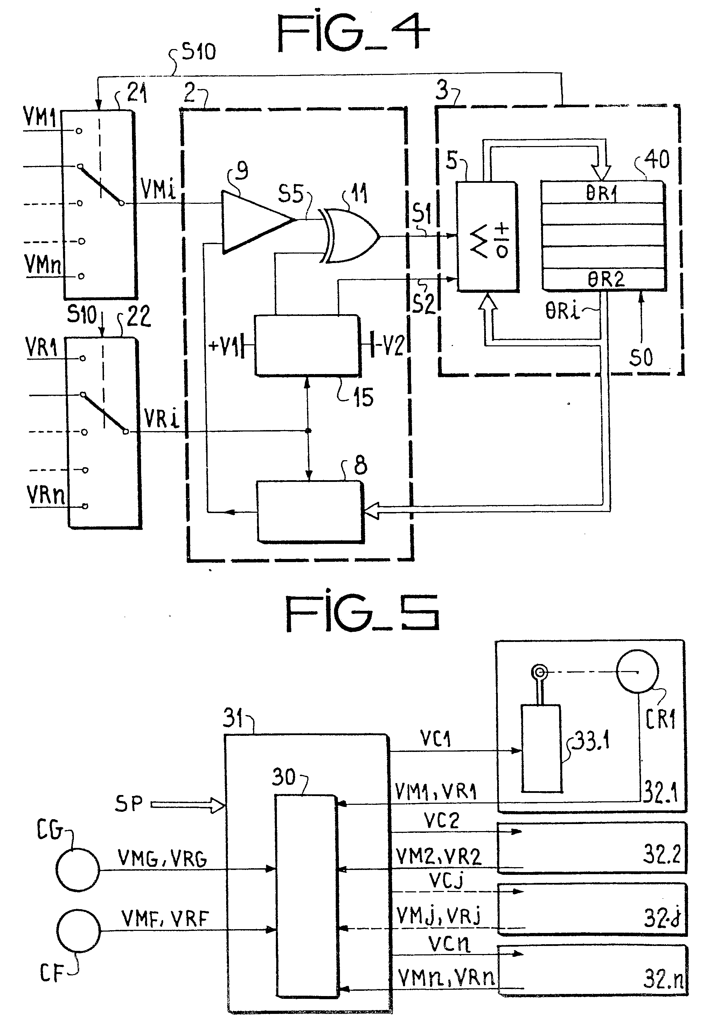

La commande du circuit additionneur-soustracteur 5 par le signal incrémentation décrémentation S1 est validée par un signal S2. La validation peut être déterminée pour jouer, soit sur la valeur absolue de l'increment (incrément ou zéro), soit par inhibition de l'horloge S0 (ce qui revient à garder la valeur précédente). Compte tenu de la non-corrélation de la fréquence d'horloge choisie et de celle 1/T des signaux à traiter, les prélèvements vont se produire à différents instants du cycle et en particulier aux instants de passage à zéro des différents signaux. A ces instants et à leur voisinage, la comparaison par les circuits 9 et 10 n'a plus de sens et va se traduire par un bruit. Pour éviter ce bruit et la perturbation du fonctionnement qui en résulte, le résultat S1 des comparaisons est invalidé dans une plage correspondant au voisinage des passages à zéro. Pour ce faire, le comparateur 10 est associé à un troisième comparateur 12 à sortie numérique et à un circuit OU 13. Le signal de référence $V_R$ est comparé en 10 à une tension $V_1$ positive et de faible amplitude et en 12 à une tension $V_2$ négative et également de faible amplitude. Les valeurs V1, V2 sont choisies pour déterminer la plage $\Delta T$ d'interdiction de prélèvement autour des passages à zéro. Le fonctionnement apparaît sur les courbes de la figure 3 où S7 représente la sortie du comparateur 12 transmise avec S6 au circuit OU 13 pour obtenir le signal de validation S2.

Les signaux d'entrée $V_M$ et $V_R$ peuvent avoir une forme quelconque (sinusoïdaux, rectangulaires, trapézoïdaux, etc. . .) dans la mesure où, à tout instant, le signal de mesure à coder et le signal de référence peuvent être déduits l'un de l'autre par homothétie. La forme rectangulaire est particulièrement avantageuse pour un tel circuit de traitement puisque l'indétermination du rapport $V_M/V_R$ ne se produit plus alors qu'aux instants de transitions (fronts verticaux des signaux rectangulaires). A noter également, que la fréquence 1/T des signaux n'intervient pratiquement pas dans le procédé utilisé excepté pour le choix de la cadence d'horloge et en conséquence cette fréquence peut être différente d'un capteur à l'autre.

La figure 4 représente le circuit de traitement précédemment décrit auquel il est adjoint notamment des moyens de multiplexage pour traiter une pluralité de signaux issus de n capteurs. Le sous-ensemble numérique 3 peut faire partie du calculateur équipant le système ou être constitué par un automate éventuellement réalisé par un microprocesseur. Les circuits multiplexeurs 21 et 22 sont commandés séquentiellement à partir du calculateur par une commande S10 de manière à sélectionner successivement les signaux respectifs $V_{Mi}$ et $V_{Ri}$ au cours d'une période de temps T' déterminée, puis répéter cette sélection au cours de la période suivante, et ainsi de suite. De manière conjuguée les différentes valeurs $\theta_{R1}$ à $\theta_{Rn}$ stockées dans une mémoire 40 sont extraites tour à tour au cours de chaque période T', ainsi $\theta_{Ri}$ est extraite lorsque la paire $V_{Mi}$ et $V_{Ri}$ est sélectionnée. La durée de commutation par le signal S10 est égale ou multiple de la période d'horloge S0 selon que l'on désire traiter un ou plusieurs échantillons à la fois. La valeur $\theta_{Ri}$ correspondra ainsi à celle précédemment stockée au cours de la période T' précédente, ou à la suite du traitement de l'échantillon précédent. Le bloc 15 représente l'ensemble des circuits 10, 12 et 13 de la figure 1.

Suivant la solution décrite, tous les éléments sont multipléxés ce qui procure un gain en volume et en poids et une réalisation plus économique. Ce dernier point résulte également de la conversion effectuée du type numérique-analogique et non l'inverse comme indiqué dans le préambule dans le concept d'un traitement conventionnel.

Il y a lieu de remarquer par ailleurs que, au cours de chaque cycle d'horloge la valeur $\theta_{Ri}$ ne pouvant être réactualisée que d'un incrément, un parasite isolé qui serait pris en compte se traduira par une erreur limitée à un quantum d'intégration; le système produit ainsi un filtrage efficace des parasites et un accroissement de la fiabilité.

La figure 5 est relative à une application à un dispositif de commandes électriques de vol. Les commandes électriques de vol ont pour fonction de transmettre les ordres de braquage des surfaces de gauchissement et d'aérofreinage. Ces ordres sont élaborés au moyen d'un calculateur numérique à partir des ordres de commande donnés par le pilote ou le copilote en actionnant des commandes correspondantes. Un volant de gauchissement non figuré entraîne le rotor d'un capteur inductif alternatif CG qui délivre l'ordre de commande $V_{MG}$ sur l'enroulement induit. Une manette d'aérofreins non figurée entraîne de même un deuxième capteur du type potentiomètre inductif linéaire CF qui délivre sur l'enroulement rotor l'ordre de commande $V_{MF}$. Ces ordres avec les tensions de référence correspondantes sont transmis à un circuit de traitement 30 conforme à l'invention représenté dans un bloc 31 qui regroupe ce circuit avec le calculateur numérique et ses circuits périphériques. Les surfaces de gauchissement et d'aérofreinage 32-1 à 32-n comportent chacune un asservissement de position, tel un vérin 33-j alimenté par l'ordre de commande $V_{CJ}$ correspondant, et un capteur $C_{RJ}$ du type considéré qui assure la recopie de position par le signal induit $V_{MJ}$ correspondant. Les signaux de recopie $V_{M1}$ à $M_{Mn}$ et les signaux de référence $V_R$ à $V_{Rn}$ sont transmis au circuit 30. A l'aide de paramètres avions SP (vitesse propre, nombre de mach, etc...), des données $\Theta_{RG}$, $\Theta_{RF}$ et $\Theta_{R1}$ à $\Theta_{Rn}$ élaborées comme il a été décrit précédemment, le calculateur détermine par le calcul les ordres de braquage $V_{C1}$ à $V_{Cn}$ et assure le rebouclage des asservissements hydrauliques ainsi que la surveillance du système. Dans cette application, le nombre n peut être par exemple égal à six ce qui donne huit capteurs du type linvar à acquérir. Les linvars peuvent être rotatifs pour les commandes pilotes ($C_G$ et $C_F$) et linéaires pour la recopie de position des gouvernes ($C_{R1}$ à $C_{Rn}$).

Les potentiomètres inductifs linéaires ou linvars sont des capteurs inductifs alternatifs de position qui ont la propriété de former une tension proportionnelle à une position, par variation du couplage entre un enroulement primaire alimenté en alternatif par une tension de référence $V_R$, et un enroulement secondaire qui délivre le signal induit $V_M$. Dans le linvar rotatif l'enroulement secondaire, ou rotor, est mobile et la tension induite est proportionnelle: à l'angle de rotation du rotor par rapport à une position de zéro électrique, à la tension $V_R$ et au rapport K de transformation primaire-secondaire. Dans le linvar linéaire les enroulements peuvent être fixes et le couplage modifié par déplacement linéaire d'un noyau plongeur; l'équation du capteur est analogue, le déplacement angulaire $\Theta$ étant remplacé par le déplacement linéaire. Des moyens sont généralement prévus pour compenser l'influence des variations de température qui modifie la valeur du rapport K de transformation; ces moyens peuvent consister en un troisième enroulement. L'acquisition des linvars revient à calculer le rapport $V_M/V_R$, ces deux tensions s'annulant aux mêmes instants et ne présentant donc que deux états possibles 0 ou $\pi$ pour leur déphasage, signaux en phase ou en opposition de phase.

Le dispositif décrit à l'aide de la figure 5 est transposable à tout dispositif comparable comportant des asservissements de position et des capteurs d'ordre et de recopie du type envisagé. L'invention peut ainsi s'appliquer notamment dans le domaine de la commande numérique des machines outils.

## Revendications

1. Circuit de traitement de signaux analogiques périodiques comportant une mémoire (4, 40) commandée par un signal d'horloge (S0) et rebouclée sur elle-même à travers un additionneur-soustracteur (5), un convertisseur numérique-analogique (6) alimenté par la sortie mémoire, un comparateur différentiel (9) pour comparer un signal analogique à traiter avec la sortie du convertisseur (6) et un circuit de commande à l'incrémentation et à la décrémentation du circuit additionneur-soustracteur (5) à partir de la sortie du comparateur (9), ledit circuit de traitement étant destiné à traiter les signaux analogiques d'une pluralité n de capteurs du type potentiomètre inductif linéaire délivrant chacun un signal induit $V_{Mi}$ proportionnel au déplacement à mesurer et au signal de référence $V_{Ri}$ alimentant le capteur en vue exploitation de ces signaux par un calculateur numérique annexe, et étant caractérisé en ce que le comparateur (9) est à sortie numérique, que le circuit de commande comporte des moyens d'élaboration (10, 11) du signal de commande d'incrémentation-décrémentation (S1) pour préciser une information absolue de la comparaison lorsque les signaux à comparer sont de polarité opposée, et des moyens de validation (10, 12, 13) de la commande d'incrémentation-décrémentation pour une amplitude du signal de référence extérieure à une plage ($+V_1$ à $-V_2$) déterminée correspondant aux passages synchrones à zéro des signaux $V_{Mi}$ et $V_{Ri}$ à traiter, et qu'il comporte, en outre, un multiplexeur (21, 22) permettant d'appliquer successivement les 2n signaux des capteurs en transmettant à chaque fois le signal induit avec le signal de référence du capteur correspondant, un circuit multiplicateur (7) interposé entre la sortie du convertisseur (6) et le comparateur (9) pour multiplier le signal de référence par la valeur stockée en mémoire (4, 40) convertie en analogique, en sorte de mémoriser successivement les valeurs $V_{Mi}/V_{Ri}$ représentatives des déplacements respectifs du capteur.

2. Circuit selon la revendication 1, caractérisé en ce que lesdits moyens d'élaboration comportent un deuxième comparateur à sortie numérique (10) recevant le signal de référence et délivrant l'information de signe (S6) correspondante de ce signal, et un circuit OU exclusif (11) alimenté par les comparateurs (9, 10) et délivrant le signal d'incrémentation-décrémentation (S1) à l'additionneur-soustracteur (5).

3. Circuit selon la revendication 1 ou 2, caractérisé en ce que les moyens de validation utilisent le second comparateur (10) pour comparer le signal de référence à une tension positive +V₁, un troisième comparateur à sortie numérique (12) pour comparer ce signal à une tension négative −V₂, et un circuit OU (13) alimenté par les sorties de ces deux comparateurs (10, 12) et délivrant un signal de validation (S2) correspondant à l'additionneur-soustracteur (5).

4. Circuit selon l'une quelconque des revendications 1 à 3, caractérisé en ce que la mémoire (40) et le circuit additionneur-soustracteur (5) font partie d'un micro-processeur qui assure le cadencement des prélèvements successifs en mémoire et qui commande le multiplexeur (21, 22).

5. Circuit selon l'une quelconque des revendications 1 à 3, caractérisé en ce que la mémoire (40) et le circuit additionneur soustracteur (5) font partie du calculateur numérique (3, 31) qui assure le cadencement des prélèvements successifs en mémoire et qui commande le multiplexeur (21, 22).

6. Dispositif de commandes électriques de vol utilisant un circuit selon la revendication 3 ou selon l'un des ensembles de revendications 3 se référant à 4 et 3 se référant à 5, caractérisé en ce que les capteurs du type potentiomètre inductifs linéaires comportent un capteur (CG) élaborateur d'ordre de gauchissement, un capteur (CF) élaborateur d'ordre d'aérofreinage, et une pluralité de capteurs de recopie (C$_{R1}$ à C$_{Rn}$) répartis sur les surfaces respectives à commander par l'intermédiaire d'asservissements de position (33-1 à n), le circuit de traitement et le calculateur numérique élaborant à partir des ordres de gauchissement et d'aérofreinage ainsi que des signaux de recopie les ordres de commande des asservissements de surface.

**Patentansprüche**

1. Stromkreis zur Verarbeitung von periodischen Analogsignalen mit einem durch ein Zeitgebersignal (50) gesteuerten und über eine Addier-Subtrahiereinrichtung (5) rückgeschleiften Speicher (4, 40), einem vom Ausgang des Speichers gespeisten Numerisch-Analog-Wandler (6), einem Differentialvergleicher (9) zum Vergleichen eines zu verarbeitenden Analogsignals mit dem Ausgang des Wandlers (6), und mit einem Inkrementierungs- und Dekrementierungssteuerkreis für die Addier-Subtrahiereinrichtung (5) vom Ausgang des Vergleichers (9) ab, wobei der Verarbeitungskreis zur Verarbeitung der Analogsignale einer Anzal n von Meßwertfühlern des linearen induktiven Potentiometertyps bestimmt ist und jeder dieser Meßwertfühler ein induziertes, der zu messenden Versetzung proportionales Signal V$_{Mi}$ abgibt, und wobei dieses Signal V$_{Mi}$ ebenfalls dem Bezugssignal V$_{Ri}$ proportional ist, das den Meßfühler zwecks Auswertung dieser Signale vermittels einer zusätzlichen numerischen Recheneinrichtung speist, dadurch gekennzeichnet, daß der Vergleicher (9) einen numerischen Ausgang hat, daß der Steuerkreis Mittel (10, 11) zur Gewinnung des Inkrementierungs-Dekrementierungs-Steuersignals (51) besitzt, um eine absolute Information bezüglich des Vergleichs zu präzisieren, wenn die zu vergleichenden Signale entgegengesetzte Polaritäten besitzen, ferner Mittel (10, 13) zum Gültigmachen der Inkrementierungs-Dekrementierungssteuerung, wenn die Amplitude des äußeren Bezugssignals innerhalb einer bestimmten Wertspanne (+V₁ bis −V₂) liegt, die den synchronen Nulldurchgängen der zu verarbeitenden Signale V$_{Mi}$ und V$_{Ri}$ entspricht, und daß der Verarbeitungskreis ferner einen Multiplexer (21, 22) aufweist, der es gestattet, die 2n Signale der Meßwertfühler nacheinander anzulegen und dabei jeweils das induzierte Signal mit dem Bezugssignal des betreffenden Meßfühlers überträgt, sowie einen Multiplikationskreis (7), der zwischen dem Ausgang des Wandlers (6) und dem Vergleicher (9) angeordnet ist, um das Bezugssignal mit dem im Speicher (4, 40) gespeicherten und in einen Analogwert umgewandelten Wert zu multiplizieren, derart, daß die die jeweiligen Versetzungen des Meßfühlers darstellenden Werte V$_{Mi}$/V$_{Ri}$ nacheinander gespeichert werden.

2. Stromkreis nach Anspruch 1, dadurch gekennzeichnet, daß die genannten Mittel zur Gewinnung einen zweiten Vergleicher mit numerischem Ausgang (10) besitzen, der das Bezugssignal empfängt und die diesem Signal entsprechende Zeicheninformation (S6) abgibt, ferner einen EXKLUSIV-ODER Stromkreis (11), der von den Vergleichern (9, 10) gespeist wird und das Inkrementierungs-Dekrementierungs-Signal (S1) an die Addier-Subtrahiereinrichtung (5) überträgt.

3. Stromkreis nach Anspruch 1 oder 2, dadurch gekennzeichnet, daß die Mittel zum Gültigmachen den zweiten Vergleicher (10) benutzen, um das Bezugssignal mit einer positiven Spannung +V₁ zu vergleichen, während ein dritter Vergleicher mit numerischem Ausgang (12) dieses Signals mit einer negativen Spannung −V₂ vergleicht und ein ODER-Stromkreis (13) von den Ausgängen dieser beiden Vergleicher (10, 12) gespeist wird und ein entsprechendes Gültigkeitssignal (S2) an die Addier-Subtrahiereinrichtung (5) abgibt.

4. Stromkreis nach einem der Ansprüche 1 bis 3, dadurch gekennzeichnet, daß der Speicher (40) und die Addier-Subtrahiereinrichtung (5) zu einem Mikroprocesser gehören, der den Takt der nacheinander erfolgenden Speicherentnahmen regelt und den Multiplexer (21, 22) steuert.

5. Stromkreis nach einem der Ansprüche 1 bis 3, dadurch gekennzeichnet, daß der Speicher (40) und die Addier-Subtrahiereinrichtung (5) zu einer numerischen Recheneinrichtung (3, de l'inversion gehören, die die nacheinander erfolgenden Speicherentnahmen regelt und den Multiplexer (21, 22) steuert.

6. Elektrisches Flugsteuergerät mit einem Stromkreis nach Anspruch 3 oder gemäß einer der Kombinationen der Ansprüche 3 und 4 bzw. 3 und 5, dadurch gekennzeichnet, daß die Meßwertfühler vom induktiven lineraren Potentiometertyp einen Meßwertfühler (CG) zur Erzeugung von Verwindungsbefehlen, einen Meßwertfühler (CF) zur Erzeugung von Luftbremsbefehlen, sowie eine Mehrzahl von auf den betreffenden, vermittels die Stellung bestimmender Servovorrichtungen (33-1 bis n) bedienbaren Flächen verteilten Kontroll-Meßwertfühlern ($C_{R1}$ bis $C_{Rn}$) umfassen, wobei der Verarbeitungskreis und die numerische Recheneinrichtung aufgrund der Verwindungsbefehle und der Luftbremsbefehle, sowie aufgrund der Kontrollsignale die Befehle zur Steuerung der den Flächen zugeordneten Servovorrichtungen ausarbeiten.

**Claims**

1. Circuit for processing periodical analog signals, comprising a memory (4, 40) controlled by a clock signal (50) and self-looped through an adder-subtractor (5), a digital-to-analog con· ·rter (6) fed by the memory output, a differential comparator (9) for comparing an analog signal to be processed with the converter (6) output and an increment-decrement circuit for controlling the adder-subtracter (5) by the comparator (9) output, said processing circuit being intended for processing analog signals from a plurality n of sensors of the linear inductive potentiometer type, each of which sensors provides an induced signal $V_{Mi}$ proportional to a displacement to be measured and to a reference signal $V_{Ri}$ provided to the sensor, for the processing of these signals by an associated digital computer, and being characterized in that the comparator (9) has a digital output, in that the control circuit comprises means (10, 11) for forming the increment-decrement control signal (S1) to define accurately absolute information about the comparison when the signals to be compared are of opposite polyrity, enabling means (10, 12, 13) acting on the increment decrement control when the reference signal amplitude is out of a determined range ($+V_1$ to $-V_2$) corresponding to the synchronous passages at a null of the $V_{Mi}$ and $V_{Ri}$ signal to be processed, and further comprises a multiplexer (21, 22) for feeding in succession the 2n signals from the sensors by transmitting each time the induced signal with the reference signal of the corresponding sensor, a multiplier circuit (7) arranged between the converter (6) output and comparator (9) to multiply the reference signal by the value put into memory (4, 40) and analog converted, so as to put successively into the memory the $V_{Mi}/V_{Ri}$ values representative of the respective displacements of the sensor.

2. Circuit according to claim 1, characterized in that said forming means comprise a second comparator having a digital output (10) which receives the reference signal and which provides the sign information (S6) corresponding to that signal, and an exclusive-OR circuit (11) fed by comparators (9, 10) for providing the increment-decrement signal (51) to the adder-subtracter (5).

3. Circuit according to claim 1 or 2, characterized in that the enabling means make use of the said comparator (10) for comparing the reference signal to a positive voltage $+V_1$, of a third comparator (12), having a digital output for comparing that signal to a negative voltage $-V_2$, and of an OR circuit (13) fed by the outputs of comparators (10, 12) for forming a corresponding enabling signal (S2) to the adder-subtracter (8).

4. Circuit according to any one of claims 1 to 3, characterized in that memory (40) and adder-subtracter (5) are part of a microprocessor which controls the rate of the seccessive memory samplings and which controls the multiplexer (21, 22).

5. Circuit according to any one of claims 1 to 3, characterized in that memory (40) and adder-subtracter (5) are part of a digital computer (3, 31) which controls the rate of the successive memory samplings and which controls the multiplexer (21, 22).

6. Flight electric control device comprising a circuit according to claim 3 or according to one of claims 4 and 5 when they refer to claim 3, characterized in that the sensors of the linear induction potentiometer type comprise a sensor (CG) for generating warping orders, a sensor (CF) for generating air-tracking orders and a plurality of recopy sensors ($C_{R1}$ to $C_{Rn}$) distributed on respective surfaces to be controlled through position servo controllers (33-1 to -n), the processing circuit and the digital computer generating surface servo control orders from the warping and air-tracking orders as well as from the recopy signals.

FIG_1

FIG_3

# FIG_2-a

# FIG_2-b

# FIG_2-c

# FIG_2-d

# FIG_4

# FIG_5